Europäisches Patentamt

European Patent Office

Office européen des brevets

(19)

(11) **EP 1 004 884 B1**

(12) **FASCICULE DE BREVET EUROPEEN**

(45) Date de publication et mention
de la délivrance du brevet:
**31.07.2002 Bulletin 2002/31**

(51) Int Cl.⁷: **G01R 31/08**

(21) Numéro de dépôt: **99402904.9**

(22) Date de dépôt: **23.11.1999**

(54) **Procédé et dispositif de détection d'un arc interne dans une liaison électrique sous enveloppe métallique**

Gerät und Verfahren zur Erfassung von internen Lichtbogenfehlern in einem metallgekapselten Leiter

Method and device for the detection of internal arcing in an electric conductor in a metal casing

(84) Etats contractants désignés:
**CH DE FR GB LI**

(30) Priorité: **25.11.1998 FR 9814819**

(43) Date de publication de la demande:
**31.05.2000 Bulletin 2000/22**

(73) Titulaire: **Alstom Holdings**
**75116 Paris (FR)**

(72) Inventeur: **Marmonier, Jean**
**73100 Aix les Bains (FR)**

(74) Mandataire: **Gosse, Michel et al**
**ALSTOM**
**Intellectual Property Department**
**25,avenue Kléber**
**75116 Paris (FR)**

(56) Documents cités:
**WO-A-97/10515**     **FR-A- 2 402 877**
**US-A- 4 957 007**     **US-H- H 536**

• **PATENT ABSTRACTS OF JAPAN vol. 13, no. 1 (P-808), 6 janvier 1989 (1989-01-06) & JP 63 210676 A (KANSAI ELETRIC POWER), 1 septembre 1988 (1988-09-01)**

## Description

La présente invention concerne un procédé et un dispositif destinés à la détection d'un arc interne dans une liaison électrique sous enveloppe métallique, en particulier pour des liaisons de grande longueur, par exemple de 100 m.

Lorsqu'il se produit un courant de court-circuit dans une liaison électrique sous enveloppe métallique, il se crée une augmentation de la pression dans l'enveloppe au niveau du défaut et cela se traduit par deux ondes de surpression qui se propagent chacune dans une direction à partir de l'endroit où a eu lieu le courant de court-circuit . La détection de cette onde de surpression permet de révéler l'apparition d'un défaut dans la ligne. Il est particulièrement intéressant de localiser l'endroit où le défaut s'est produit pour détecter des défauts répétitifs.

Actuellement, la détection de l'onde de surpression créée par le courant de court-circuit est réalisée en mesurant l'accroissement de la pression moyenne au moyen d'un capteur de pression. On peut utiliser à cet effet les transmetteurs de densité destinés à surveiller la densité du gaz dans le tronçon considéré de l'enveloppe et constitués par un capteur de pression dans lequel on réalise une i compensation de la mesure en fonction de la température pour obtenir la densité du gaz.

La surpression créée est relativement faible, par exemple de l'ordre de 10 %, et l'onde de surpression qui se propage dans l'enveloppe à partir du point de défaut s'atténue lors de sa propagation et sa valeur diminue lorsque l'on s'éloigne du point de défaut. Il en résulte que la sensibilité de ces détecteurs est faible et que l'on peut ne pas toujours détecter des défauts se produisant dans des tronçons de grande longueur.

Le document JP 63210676 décrit un procédé pour localiser un arc se produisant entre un conducteur électrique et son enveloppe. Le procédé est fondé sur la détection de l'onde de surpression interne résultant de l'échauffement local, dit à l'arc, se propageant le long de l'enveloppe.

La détection du passage du front de montée d'une onde de surpression est en effet plus facile à réaliser car son amplitude est plus élevée que la variation de pression moyenne, ce qui augmente notablement la sensibilité du capteur.

La présente invention a pour but d'améliorer la sensibilité de la détection de l'arc et elle a ainsi pour objet un procédé de détection d'un arc interne dans une liaison électrique sous enveloppe métallique dans lequel on détecte, à un emplacement fixe de l'enveloppe, le front de montée de l'onde de surpression interne créé par l'arc et se propageant dans l'enveloppe, caractérisé en ce que l'on mesure en permanence, pendant deux durées égales, inférieures au temps de passage du front de montée et séparées par un intervalle de temps inférieur au temps de passage du front de montée, la pression dans l'enveloppe, en ce que l'on intègre par rapport au temps la courbe pendant ces deux durées, en ce que l'on détermine la différence entre les deux valeurs d'intégration et en ce que l'on compare la différence, de pression obtenue, à une valeur de seuil.

On surveille ainsi en permanence la pression du gaz diélectrique et cet algorithme permet de mesurer deux valeurs de la pression à deux instants voisins et la valeur obtenue est indépendante de la valeur de pression continue, sujette à des fluctuations éventuelles. Il en résulte une amélioration sensible de la précision et, par suite, de la sensibilité de la détection du passage de la surpression.

Avantageusement, les durées de mesure sont sensiblement égales à la moitié du temps de passage du front de montée et l'intervalle de temps est sensiblement égal à la moitié du temps de passage du front de montée. Ce temps de passage dépend de la vitesse de propagation des ondes de pression dans le gaz diélectrique.

Ceci permet de comparer la valeur de la pression pendant deux durées correspondant respectivement sensiblement au début du front de montée et à sa fin de telle sorte que la différence entre les valeurs intégrées est maximale.

Selon encore une autre caractéristique de l'invention, la détection est effectuée sensiblement au milieu du tronçon d'enveloppe à surveiller.

De cette manière, la sensibilité est encore améliorée car l'atténuation de la surpression lors de sa propagation est limitée à celle correspondant à la moitié de la longueur du tronçon à surveiller.

L'invention a également pour objet un dispositif pour la mise en oeuvre du procédé précité, caractérisé en ce qu'il comporte au moins une unité de détection unidirectionnelle constituée par un capteur de pression disposé à l'extérieur de l'enveloppe et relié à l'intérieur de l'enveloppe par l'intermédiaire d'un conduit en forme de cornet qui est incliné par rapport à l'axe de l'enveloppe, dont l'embouchure débouche dans l'enveloppe et dont la pointe est reliée au capteur.

L'interface ainsi réalisée entre le tronçon à surveiller et le capteur permet tout d'abord d'améliorer la sensibilité du fait de la surpression supplémentaire créée par le conduit qui constitue une sorte d'entonnoir. Par ailleurs, l'unité de détection ainsi formée agit de manière unidirectionnelle et n'est sensible qu'aux vagues de surpression provenant de la direction opposée à la direction de l'inclinaison du conduit.

Avantageusement, on prévoit un ensemble d'au moins deux unités de détection unidirectionnelle de même sens de détection disposées au voisinage l'une de l'autre et dont les conduits sont inclinés dans le même sens.

Cette disposition permet d'obtenir une redondance par rapport à la localisation du défaut en palliant la défaillance d'un capteur.

On peut prévoir deux ensembles de détection unidirectionnelle dont les conduits sont inclinées de manière opposée et qui sont disposés au voisinage l'un de l'autre.

De cette manière, en utilisant quatre unités de détection, on peut détecter et localiser avec une bonne sensibilité et une grande fiabilité des défauts se produisant des deux côtés des ensembles de détection.

Selon un mode de réalisation de l'invention, on utilise deux capteurs de pression reliés en parallèle à deux conduits inclinées de manière opposée et dont les pointes sont en communication l'une avec l'autre.

Cette disposition permet de réaliser un dispositif détecteur bidirectionnel de grande sensibilité et présentant une redondance en ce qui concerne la détection, puisque les capteurs sont doublés.

Selon un autre mode de réalisation de l'invention, on utilise deux unités de détection directionnelles dont les conduits sont inclinés de manière opposée.

On obtient ainsi un dispositif de détection bidirectionnel qui permet de localiser les défauts mais qui ne présente pas de sécurité contre la défection d'un capteur.

Avantageusement, pour ces deux modes de réalisation, on utilise les deux capteurs destinés à la surveillance de la densité du gaz diélectrique. Ceci permet de réaliser un dispositif de détection avec un faible surcoût.

D'autres caractéristiques et avantages de l'invention ressortiront de la description qui suit, faite à titre illustratif et nullement limitatif, en se référant aux dessins ci-annexés sur lesquels:

la figure 1 est une analogie hydraulique expliquant le phénomène de la "vague" de pression,
la figure 2 décrit l'algorithme utilisé,
la figure 3 illustre l'amplification obtenue par le conduit d'interface,
la figure 4 illustre un dispositif de détection bidirectionnel selon l'analogue hydraulique,
la figure 5 représente un mode de réalisation d'un tel dispositif de détection bidirectionnel,
la figure 6 représente un mode de réalisation d'un dispositif de détection unidirectionnel à deux capteurs et
la figure 7 est une vue en coupe du dispositif de la figure 6.

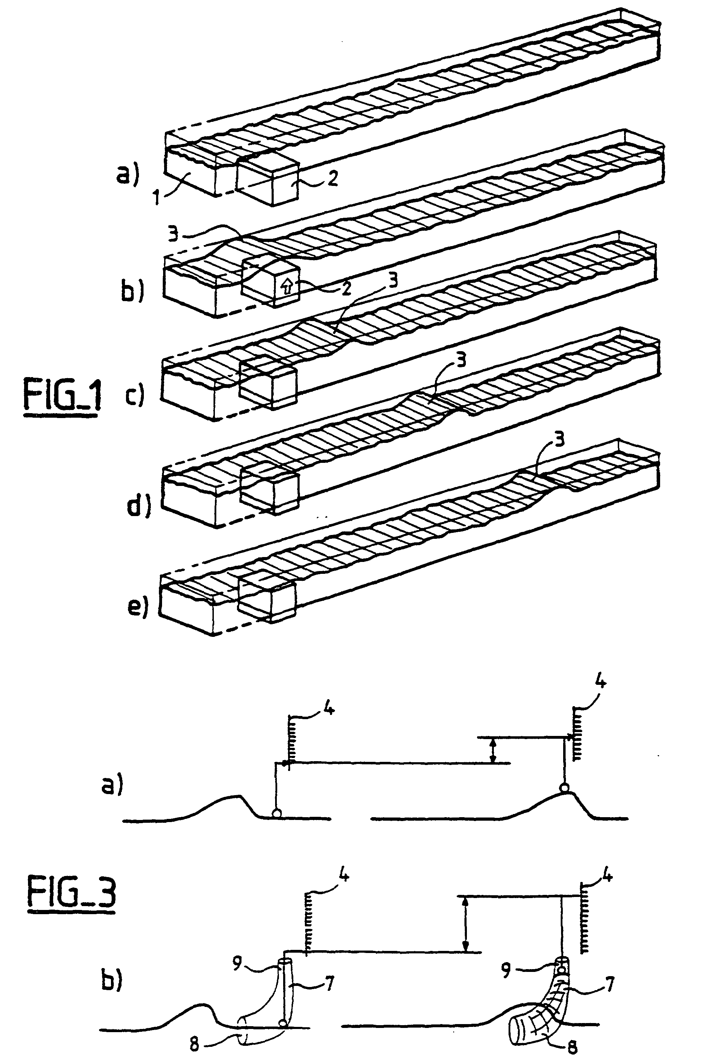

Sur la figure 1, on a illustré une analogie hydraulique du phénomène créé par un courant de court-circuit dans une liaison électrique sous enveloppe métallique, encore appelée câble blindé, dont les tronçons peuvent atteindre des longueurs importantes, par exemple plus de 100 m.

Il faut tout d'abord rappeler que, sur une période de temps courte, de l'ordre de quelques secondes dans le présent cas, le phénomène de surpression peut être considéré comme étant adiabatique puisque les échanges thermiques avec l'extérieur peuvent être négligés sur cette période de temps. Il en résulte que l'énergie calorifique apportée par le courant d'arc interne créera une augmentation de la pression moyenne dans le tronçon concerné.

On peut faire une analogie avec un canal hydraulique 1 comportant à un endroit de son fond un large système 2 à cylindre et piston comme représenté sur la figure 1a. L'élévation de ce piston (figure 1b) provoquera une augmentation du niveau moyen de l'eau dans ce canal.

Il est clair que, si ce canal est de grande longueur, cette augmentation de niveau sera négligeable et difficilement détectable ; de manière analogue, il est difficile de détecter un arc interne par l'augmentation de la pression moyenne dans un tronçon de câble blindé de grande longueur.

En fait, il apparaît, de chaque côté du système 2, une vague 3 dont l'amplitude est fonction des caractéristiques (dimensions, vitesse du piston) du système 2. Cette vague se propage en s'éloignant de l'emplacement du système 2 comme on le voit sur les figures 1c à 1e.

L'amplitude de la variation du niveau de l'eau à l'endroit de cette vague est beaucoup plus importante que la variation du niveau moyen et cette variation est donc beaucoup plus facile à détecter.

Si l'on considère un tronçon de câble blindé, par analogie, il se crée une "vague" ou onde de surpression qui est plus facile à détecter que la variation de la pression moyenne. Cela a été vérifié expérimentalement par la demanderesse.

C'est pourquoi l'invention propose de détecter le passage de cette onde de surpression, et plus précisément du front de montée de cette onde qui est relativement raide et crée donc une variation rapide. On peut donc améliorer fortement la sensibilité de la détection des arcs internes.

La figure 2 illustre l'algorithme d'une méthode de détection de ce front de montée. Avec un capteur de pression raccordé à l'enveloppe, on mesure en permanence la pression du gaz diélectrique dans cette dernière. Les figures 2a et 2b montrent la variation de la pression, P, due au passage de l'onde de surpression en fonction du temps, t, au niveau du capteur 4.

Cette mesure est intégrée en permanence pendant deux durées voisines de 40 ms, à savoir de t - 120 ms à t - 80 ms et de t - 40 ms à t. Ces deux durées sont égales à 40 ms et séparées par un intervalle de temps qui est aussi de 40 ms. Cette durée de 40 ms est sensiblement égale à la moitié du temps de passage du front de montée 5 de l'onde 6 de surpression au niveau du capteur. Cela permet, comme on le voit sur la figure 2b, de mesurer et de comparer la valeur normale de la pression pendant la durée t -120 ms à t -80 ms et une valeur voisine de la crête de pression pendant la durée t -40 ms à t. On calcule la différence, Δ, des deux valeurs intégrées

$$\Delta = \int_{t-40}^{t} Pdt - \int_{t-120}^{t-80} Pdt$$

Si cette différence Δ, qui est positive pendant le passage du front de montée 5 de l'onde de surpression 6, est supérieure à une valeur de seuil ΔP, qui est représentée sur la figure 2b et qui est légèrement inférieure à la valeur minimale possible de la surpression créée par l'arc interne, on en conclut qu'il y a eu un courant de défaut interne dans le tronçon de câble blindé sur lequel est placé le capteur de pression.

Comme représenté sur la figure 3, selon une autre caractéristique de l'invention, pour améliorer encore la sensibilité de la mesure, le capteur 4 est relié à l'enveloppe par un conduit 7 qui, pour reprendre l'analogie hydraulique, présent une forme et direction adaptées pour former une "écope" recevant la "vague" de surpression.

Ce conduit 7 a la forme d'un cornet constituant un entonnoir. L'embouchure 8 de ce conduit 7 est reliée à l'enveloppe du tronçon à surveiller et sa pointe 9 est reliée au capteur de pression.

Comme cela est illustré sur la figure 3, la différence de pression simple représentée sur la figure 3a est amplifiée par le conduit 7 du fait de la surpression créée par le rétrécissement de la section de ce conduit 7 (figure 3b). On peut ainsi déterminer un seuil de détection ΔP qui est de l'ordre de 100mb à 300mb dans le cas d'un câble blindé à hexafluorure de soufre. Cette valeur de seuil est déterminée en fonction du gaz diélectrique utilisé et de sa densité dans l'enveloppe.

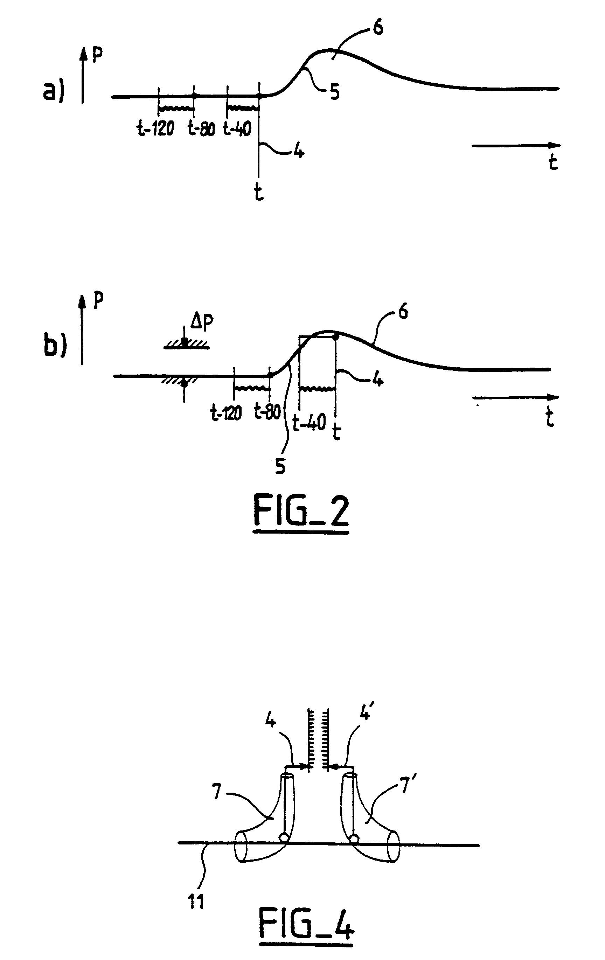

Sur la figure 4, on a représenté un ensemble de deux unités de détection unidirectionnelle voisines constituées chacune par un conduit 7, respectivement 7', relié à un capteur 4, respectivement 4'. Les deux conduits 7 et 7' sont inclinés par rapport à l'axe de l'enveloppe 11 dans des directions opposées, le conduit 7 étant incliné vers la droite et le conduit 7' vers la gauche, de telle sorte que chacun des capteurs 4 et 4' n'est sensible qu'aux ondes de surpression provenant de la direction opposée à son inclinaison, le capteur 4 étant sensible aux ondes de surpression venant de la gauche et le capteur 4' à celles venant de la droite sur la figure 4. Cette disposition permet de localiser le défaut par rapport aux unités de détection unidirectionnelle.

Par ailleurs, si l'instant d'apparition de l'arc interne est connu au moyen du dispositif de protection du réseau, la distance entre l'endroit d'apparition de l'arc interne et l'unité de détection unidirectionnelle peut être déterminée par une simple mesure de temps, la vitesse de propagation de l'onde de surpression étant connue pour le gaz diélectrique utilisé. Ceci permet de localiser avec précision cet endroit du défaut.

Avantageusement les unités de détection unidirectionnelle sont disposées au centre du tronçon à surveiller, ce qui permet de limiter l'effet de l'amortissement de l'onde de surpression lors de sa propagation et, par suite, d'améliorer la sensibilité pour un tronçon à surveiller de grande longueur.

Les deux capteurs sont avantageusement également constitués par les capteurs utilisés pour la surveillance de l'absence de fuite en mesurant la densité du gaz diélectrique. Le dispositif de la figure 4 n'entraîne donc pas un surcoût significatif.

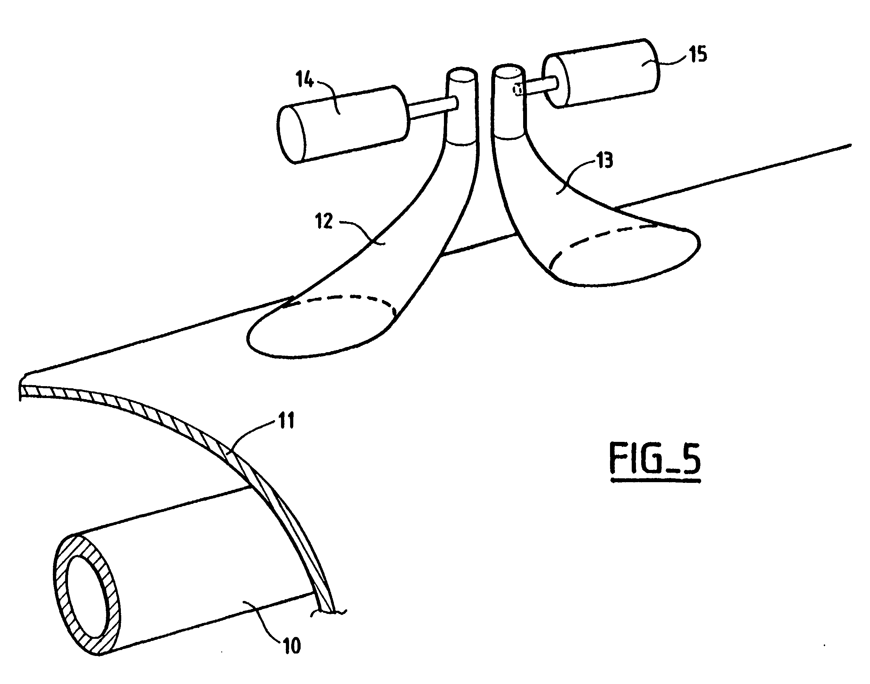

La figure 5 représente de manière schématique un ensemble de deux unités de détection unidirectionnelle positionnées sur un câble blindé comportant un conducteur central 10 disposé dans une enveloppe 11 remplie d'un gaz diélectrique sous pression tel que de l'hexafluorure de soufre SF6. Les deux conduits 12 et 13 débouchent dans l'enveloppe 11 et sont orientés dans des directions opposées. Ils sont reliés chacun à un capteur de pression de type connu, 14, respectivement 15, tels que ceux utilisés pour la surveillance de la densité du gaz diélectrique.

Pour assurer une redondance, il est avantageux de doubler les unités de détection unidirectionnelle en utilisant quatre unités disposées au même endroit, à savoir deux unités de détection à gauche et deux unités de détection à droite. De cette manière, on pallie la défection d'une unité, en particulier de son capteur et on augmente la fiabilité du système. Si les exigences en disponibilité sont très importantes, on peut tripler les unités de détection unidirectionnelle.

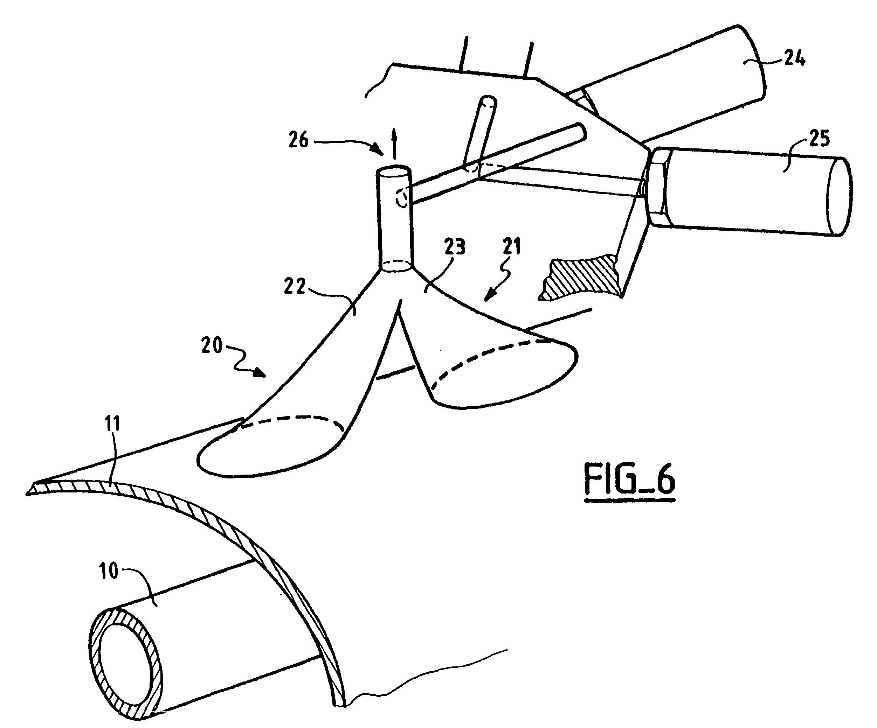

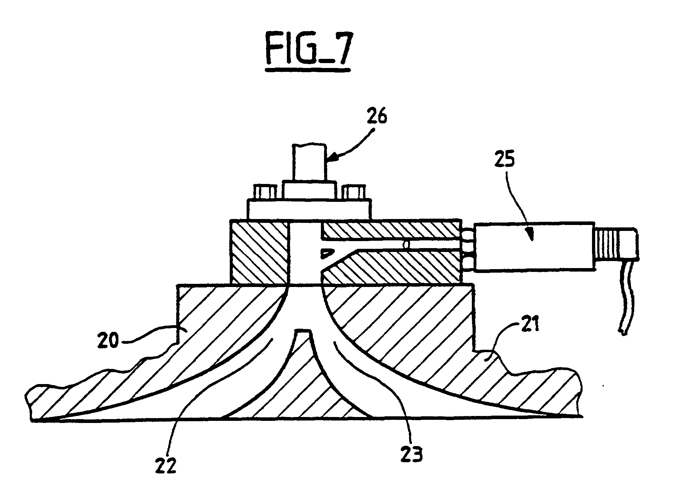

Sur les figures 6 et 7, on a représenté un autre mode de réalisation de réalisation de l'invention dans lequel on prévoit deux conduits 20 et 21 de directions opposées dont les pointes 22 et 23 sont connectées ensemble et reliées à deux capteurs 24 et 25 disposés en parallèle. Comme dans le mode de réalisation de la figure 5, ces deux capteurs sont ceux déjà mis en place sur l'enveloppe 11 pour surveiller la densité du gaz diélectrique et on voit en 26 une vanne de remplissage permettant de compenser les pertes de densité détectées.

La description ci-dessus n'a été fournie qu'à titre d'exemples non limitatifs et il est évident que l'on peut y apporter des modifications ou variantes sans pour autant sortir du cadre de l'invention tel qu'elle est définie par les revendications. En particulier, la valeur de la durée de mesure de la pression est fonction de la vitesse de propagation des ondes de pression dans le gaz diélectrique; ainsi dans le cas d'un mélange SF6-azote, cette durée sera plus courte car la vitesse de propagation est plus élevée que dans le SF6.

## Revendications

1. Procédé de détection d'un arc interne dans une liaison électrique sous enveloppe métallique (11), dans lequel on détecte, à un emplacement fixe de l'enveloppe (11), le front de montée (5) de l'onde (6) de surpression interne créée par l'arc et se propageant dans l'enveloppe (11), **caractérisé en ce que** l'on mesure en permanence, pendant deux durées égales, inférieures au temps de passage du front de montée (5) et séparées par un intervalle de temps inférieur au temps de passage du front de montée (5), la pression dans l'enveloppe, **en ce que** l'on intègre par rapport au temps la courbe pendant ces deux durées, **en ce que** l'on détermine la différence ($\Delta$) entre les deux valeurs d'intégration et **en ce que** l'on compare la différence de pression ($\Delta$) obtenue, à une valeur de seuil($\Delta$P).

2. Procédé selon la revendication 1, **caractérisé en ce que** les durées de mesure sont sensiblement égales à la moitié du temps de passage du front de montée (5).

3. Procédé selon la revendication 2, **caractérisé en ce que** l'intervalle de temps est sensiblement égal à la moitié du temps de passage du front de montée (5).

4. Procédé selon la revendication 1, **caractérisé en ce que** la détection est effectuée sensiblement au milieu du tronçon de l'enveloppe à surveiller.

5. Dispositif pour la mise en oeuvre du procédé selon l'une des revendications 1 à 4, **caractérisé en ce qu'**il comporte au moins une unité de détection unidirectionnelle constituée par un capteur de pression (4, 4', 14, 15, 24, 25) disposé à l'extérieur de l'enveloppe (11) et relié à l'intérieur de l'enveloppe (11) par l'intermédiaire d'un conduit (7, 7', 12, 13, 20, 21) en forme de cornet qui est incliné par rapport à l'axe de l'enveloppe (11), dont l'embouchure débouche dans l'enveloppe et dont la pointe (22, 23) est reliée au capteur de pression (4, 4', 14, 15, 24, 25).

6. Dispositif selon la revendication 5, **caractérisé en ce qu'**il comporte un ensemble d'au moins deux unités de détection unidirectionnelle de même sens de détection disposées au voisinage l'une de l'autre et dont les conduits sont inclinés dans le même sens.

7. Dispositif selon la revendication 6, **caractérisé en ce qu'**il comporte deux ensembles de détection unidirectionnelle dont les conduits sont inclinés de manière opposée et qui sont disposés au voisinage l'un de l'autre.

8. Dispositif selon la revendication 5, **caractérisé en ce qu'**il comporte deux capteurs de pression (24, 25) reliés en parallèle à deux conduits (20, 21) inclinées de manière opposée et dont les pointes (22, 23) sont en communication l'une avec l'autre.

9. Dispositif selon la revendication 5, **caractérisé en ce qu'**il comporte deux unités de détection directionnelles (4, 7, 4', 7' ; 12, 14 ; 13, 15) dont les conduits (7, 7' ; 14, 15) sont inclinés de manière opposée.

**Patentansprüche**

1. Verfahren zum Erfassen eines internen Lichtbogens in einer elektrischen Verbindung unter einer metallischen Hülle (11), bei dem an einem festen Ort der Hülle (11) die ansteigende Flanke (5) der von dem Lichtbogen erzeugten und sich in der Hülle (11) ausbreitenden Überdruckwelle erfasst wird, **dadurch gekennzeichnet, dass** ständig während zweier Zeitspannen, die kürzer als die Durchgangszeit der ansteigenden Flanke (5) sind und durch ein Zeitintervall getrennt sind, das kürzer als die Durchgangszeit der ansteigenden Flanke (5) ist, der Druck in der Hülle gemessen wird, dass die Kurve über die Zeit während dieser zwei Zeitspannen integriert wird, dass die Differenz ($\Delta$) zwischen den zwei Integrationswerten bestimmt wird, und dass die erhaltene Druckdifferenz ($\Delta$) mit einem Schwellwert ($\Delta$P) verglichen wird.

2. Verfahren nach Anspruch 1, **dadurch gekennzeichnet, dass** die Messzeitspannen im wesentlichen gleich der halben Durchgangszeit der ansteigenden Flanke (5) sind.

3. Verfahren nach Anspruch 2, **dadurch gekennzeichnet, dass** das Zeitintervall im wesentlichen gleich der Hälfte der Durchgangszeit der ansteigenden Flanke (5) ist.

4. Verfahren nach Anspruch 1, **dadurch gekennzeichnet, dass** die Erfassung im wesentlichen in der Mitte des zu überwachenden Stücks der Hülle erfolgt.

5. Vorrichtung zur Durchführung des Verfahrens nach einem der Ansprüche 1 bis 4, **dadurch gekennzeichnet, dass** sie wenigstens eine unidirektionale Erfassungseinheit umfasst, die durch einen Druckmessaufnehmer (4, 4>, 14, 15, 24, 25) gebildet ist, der außerhalb der Hülle (11) angeordnet und mit dem Inneren der Hülle (11) über eine hornförmige Leitung (7, 7>, 12, 13, 20, 21) verbunden ist, die in Bezug auf die Achse der Hülle (11) geneigt ist, deren Mündung in die Hülle mündet und deren Spitze (22, 23) mit dem Druckaufnehmer (4, 4>, 14, 15, 24, 25) verbunden ist.

6. Vorrichtung nach Anspruch 5, **dadurch gekennzeichnet, dass** sie eine Anordnung von wengistens zwei unidirektionalen Erfassungseinheiten mit gleicher Erfassungsrichtung umfasst, die zueinander benachbart angeordnet sind und deren Leitungen im gleichen Sinne geneigt sind.

**7.** Vorrichtung nach Anspruch 6, **dadurch gekennzeichnet, dass** sie zwei unidirektionale Erfassungsanordnungen umfasst, deren Leitungen entgegengesetzt geneigt sind und die einander benachbart angeordnet sind.

**8.** Vorrichtung nach Anspruch 5, **dadurch gekennzeichnet, dass** sie zwei Druckaufnehmer (24, 25) umfasst, die parallel an zwei Leitungen (20, 21) angeschlossen sind, die entgegengesetzt geneigt sind und deren Spitzen (22, 23) miteinander kommunizieren.

**9.** Vorrichtung nach Anspruch 5, **dadurch gekennzeichnet, dass** sie zwei gerichtete Erfassungseinheiten (4, 7, 4>, 7>; 12, 14; 13, 15) umfasst, deren Leitungen (7, 7>; 14, 15) entgegengesetzt geneigt sind.

**Claims**

**1.** A method of detecting an internal arc in a metal-clad electrical link (11), in which method the rising edge (5) of the internal pressure surge (6) generated by the arc and propagating inside the cladding (11) is detected at a fixed location along the cladding (11), the method being **characterized in that** the pressure inside the cladding is measured continuously for two equal durations shorter than the time taken by the rising edge (5) to go past, and separated by a time interval shorter than the time taken by the rising edge (5) to go past, **in that** the curve of the measurements taken during each of said durations is integrated relative to time, **in that** the difference ($\Delta$) between the two integration values is determined, and **in that** the pressure difference ($\Delta$) obtained is compared with a threshold value ($\Delta$P).

**2.** A method according to claim 1, **characterized in that** the measurement durations are substantially equal to one half of the time taken by the rising edge (5) to go past.

**3.** A method according to claim 2, **characterized in that** the time interval is substantially equal to one half of the time taken for the rising edge (5) to go past.

**4.** A method according to claim 1, **characterized in that** the detection is performed substantially in the middle of the cladding segment to be monitored.

**5.** A device for implementing the method according to any one of claims 1 to 4, **characterized in that** it comprises at least one one-way detection unit constituted by a pressure sensor (4, 4', 14, 15, 24, 25) disposed outside the cladding (11) and connected to the inside the cladding (11) via a horn-shaped duct (7, 7', 12, 13, 20, 21) which slopes relative to the axis of the cladding (11), which has its mouth opening out in the cladding, and which has its tip (22, 23) connected to the pressure sensor (4, 4', 14, 15, 24, 25).

**6.** A device according to claim 5, **characterized in that** it comprises a set of at least two one-way detection units having the same detection direction and disposed in the vicinity of each other, and whose ducts slope the same way.

**7.** A device according to claim 6, **characterized in that** it comprises two one-way detection sets whose ducts slope in mutually opposite directions and which are disposed in the vicinity of each other.

**8.** A device according to claim 5, **characterized in that** it comprises two pressure sensors (24, 25) connected in parallel to two ducts (20, 21) which slope in mutually opposite directions and whose tips (22, 23) communicate with each other.

**9.** A device according to claim 5, **characterized in that** it comprises two directional detection units (4, 7, 4', 7'; 12, 14; 13, 15) whose ducts (7, 7'; 14, 15) slope in mutually opposite directions.

FIG_1

a)
b)
c)
d)
e)

FIG_3

a)

b)

a)

b)

## FIG_2

## FIG_4

FIG_5

EP 1 004 884 B1

FIG_6

## FIG_7